(19) **Europäisches Patentamt**
**European Patent Office**
**Office européen des brevets**

(11) **EP 4 341 709 B1**

(12) **EUROPÄISCHE PATENTSCHRIFT**

(45) Veröffentlichungstag und Bekanntmachung des Hinweises auf die Patenterteilung:
**14.05.2025   Patentblatt 2025/20**

(21) Anmeldenummer: **22712576.2**

(22) Anmeldetag: **10.03.2022**

(51) Internationale Patentklassifikation (IPC):
**G01R 31/367** *(2019.01)*      **G01R 31/389** *(2019.01)*

(52) Gemeinsame Patentklassifikation (CPC):
**G01R 31/389; G01R 31/367**

(86) Internationale Anmeldenummer:
**PCT/EP2022/056247**

(87) Internationale Veröffentlichungsnummer:
**WO 2022/242927 (24.11.2022 Gazette 2022/47)**

(54) **VERFAHREN UND VORRICHTUNG ZUM SCHÄTZEN EINES INNENWIDERSTANDES EINER BATTERIEZELLE**

METHOD AND DEVICE FOR ESTIMATING AN INTERNAL RESISTANCE OF A BATTERY CELL

PROCÉDÉ ET DISPOSITIF D'ESTIMATION DE LA RÉSISTANCE INTERNE D'UNE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.05.2021   DE 102021205162**

(43) Veröffentlichungstag der Anmeldung:
**27.03.2024   Patentblatt 2024/13**

(73) Patentinhaber: **VOLKSWAGEN AKTIENGESELLSCHAFT**
**38440 Wolfsburg (DE)**

(72) Erfinder:
• **VALTR, Jiri**
  **17100 Prague 7 (CZ)**
• **VLCEK, Marian**
  **18600 Prague 8 (CZ)**
• **HRAZDIRA, Adam**
  **12800 Prague 2 (CZ)**
• **AUST, Stefan**
  **38108 Braunschweig (DE)**

(56) Entgegenhaltungen:
**CN-A- 111 426 968     JP-A- 2008 164 417**

# Beschreibung

Verfahren und Vorrichtung zum Schätzen eines Innenwiderstandes einer Batteriezelle Die Erfindung betrifft ein Verfahren und eine Vorrichtung zum Schätzen eines Innenwiderstandes einer Batteriezelle.

Batteriezellen altern mit der Zeit, was negative Auswirkungen auf die Eigenschaften hat. Das Altern äußert sich insbesondere in einem Anstieg eines Innenwiderstandes und einer Verringerung der elektrischen Kapazität der Batteriezelle. Durch Nachverfolgung des Innenwiderstandes kann eine Alterung der Batteriezelle verfolgt werden. Der Innenwiderstand kann jedoch nicht direkt gemessen werden, sondern kann nur über eine Spannung an der Batteriezelle und einen durch die Batteriezelle fließenden Strom geschätzt werden. Verschiedene Einflüsse können eine solche Schätzung jedoch erschweren: Messrauschen, eine Ungleichheit des Innenwiderstands beim Laden und Entladen, das RC-Glied-artige Verhalten der Batteriezelle sowie die Tatsache, dass ein üblicherweise beim Modellieren verwendetes Ersatzschaltungsmodell die elektrochemischen Prozesse in der Batteriezelle nicht perfekt abbilden kann.

CN111 426 968 A offenbart ein Verfahren zum Schätzen eines Innenwiderstandes einer Batteriezelle unter Verwedung von Spannungsdifferentiale. JP 2008 164417 A offenbart das Verwenden von differenzierenden Filtern in Verbindung mit dem Bestimmen des Innenwiderstands einer Batterie.

Der Erfindung liegt die Aufgabe zu Grunde, ein Verfahren und eine Vorrichtung zum Schätzen eines Innenwiderstandes einer Batteriezelle zu schaffen, mit denen der Innenwiderstand der Batteriezelle zuverlässig geschätzt werden kann.

Die Aufgabe wird erfindungsgemäß durch ein Verfahren mit den Merkmalen des Patentanspruchs 1 und eine Vorrichtung mit den Merkmalen des Patentanspruchs 7 gelöst. Vorteilhafte Ausgestaltungen der Erfindung ergeben sich aus den Unteransprüchen. Insbesondere wird ein Verfahren zum Schätzen eines Innenwiderstandes einer Batteriezelle zur Verfügung gestellt, umfassend die folgenden Maßnahmen: Erfassen einer Spannung an der Batteriezelle, Erfassen eines Stromes an der Batteriezelle, Bestimmen eines erfassten Spannungsdifferentials durch Differenzieren der erfassten Spannung mittels eines Filters, Bestimmen eines modellierten Spannungsdifferentials aus dem erfassten Strom und einem aktuellen Innenwiderstandschätzwert durch Differenzieren mittels eines Filters, Bestimmen eines Korrekturfaktors aus dem erfassten Spannungsdifferential und dem modellierten Spannungsdifferential, und Schätzen eines neuen aktuellen Innenwiderstandschätzwertes aus dem bestimmten Korrekturfaktor und dem vorherigen aktuellen Innenwiderstandschätzwert, Bereitstellen des neuen aktuellen Innenwiderstandschätzwertes als geschätzten Innenwiderstand der Batteriezelle.

Ferner wird insbesondere eine Vorrichtung zum Schätzen eines Innenwiderstandes einer Batteriezelle geschaffen, umfassend Schnittstellen, die eingerichtet sind zum Empfangen einer an der Batteriezelle erfassten Spannung und eines an der Batteriezelle erfassten Stromes, und eine Steuereinrichtung, wobei die Steuereinrichtung dazu eingerichtet ist, ein erfasstes Spannungsdifferential durch Differenzieren der erfassten Spannung mittels eines Filters zu bestimmen, ein modelliertes Spannungsdifferential aus dem erfassten Strom und einem aktuellen Innenwiderstandschätzwert durch Differenzieren mittels eines Filters zu bestimmen, einen Korrekturfaktor aus dem erfassten Spannungsdifferential und dem modellierten Spannungsdifferential zu bestimmen, und einen neuen aktuellen Innenwiderstandschätzwert aus dem bestimmten Korrekturfaktor und dem vorherigen aktuellen Innenwiderstandschätzwert zu schätzen, und den neuen aktuellen Innenwiderstandschätzwert als geschätzten Innenwiderstand der Batteriezelle bereitzustellen.

Das Verfahren und die Vorrichtung ermöglichen es, den Innenwiderstand einer Batteriezelle, insbesondere ausgehend von einem Referenzwert, anzulernen. Das Anlernen erfolgt insbesondere auf Grundlage eines differentiell bestimmten Innenwiderstands, d.h. der Innenwiderstand wird insbesondere als differentieller Innenwiderstand bestimmt. Der Referenzwert entspricht hierbei zu Anfang insbesondere dem nominellen Innenwiderstand der Batteriezelle. Der Referenzwert wird insbesondere als erster aktueller Innenwiderstandschätzwert gesetzt und dann durch die Maßnahmen des Verfahrens mit jeder aktuellen Iteration auf einen neuen aktuellen Innenwiderstandschätzwert aktualisiert. Das Aktualisieren wird hierbei wie folgt durchgeführt: Aus dem erfassten Strom und dem aktuellen Innenwiderstandschätzwert wird eine modellierte Spannung geschätzt. Aus der erfassten Spannung und der modellierten Spannung werden mittels (differenzierenden) Filtern durch Differenzieren jeweils Differentiale gebildet. Dem liegt der Gedanke zugrunde, dass gerade bei einer Änderung der Spannung (bzw. des Stroms) ein Innenwiderstand besonders gut bestimmt und angelernt werden kann. Aus dem Verhältnis der Differentiale zueinander wird ein Korrekturfaktor bestimmt. Aus dem bestimmten Korrekturfaktor und dem (vorherigen) aktuellen Innenwiderstandschätzwert wird ein neuer aktueller Innenwiderstandschätzwert geschätzt. Der neue aktuelle Innenwiderstandschätzwert wird als geschätzter Innenwiderstand der Batteriezelle bereitgestellt, insbesondere in Form eines analogen oder digitalen Signals.

**Der Vorteil** des Verfahrens und der Vorrichtung ist, dass der Innenwiderstand der Batteriezelle zuverlässig bestimmt werden kann. Das Verwenden von differenzierenden Filtern ermöglicht es, sowohl die Differentiale zu bestimmen als auch ein Messrauschen zu verringern.

Das Verfahren wird insbesondere wiederholt durchgeführt, um insbesondere fortlaufend einen aktuellen Innenwiderstandschätzwert zu erhalten und auf diese Weise das Altern der Batteriezelle über den geschätzten Innenwiderstand nachvollziehen zu können.

Die Spannung und der Strom werden insbesondere mittels hierfür eingerichteter Sensoren erfasst. Die Sensoren können auch Teil der Vorrichtung sein.

Teile der Vorrichtung, insbesondere die Steuereinrichtung, können einzeln oder zusammengefasst als eine Kombination von Hardware und Software ausgebildet sein, beispielsweise als Programmcode, der auf einem Mikrocontroller oder Mikroprozessor ausgeführt wird. Es kann jedoch auch vorgesehen sein, dass Teile einzeln oder zusammengefasst als anwendungsspezifische integrierte Schaltung (ASIC) oder feldprogrammierbares Gatterfeld (FPGA) ausgebildet sind.

Ein Teil des Verfahrens wird nachfolgend anhand von Formeln verdeutlicht. Hierbei wird davon ausgegangen, dass eine Veränderung des Stroms bzw. der Last zu einer Veränderung der erfassten Spannung führt, die proportional zum Innenwiderstand $R_0$ der Batteriezelle ist. Der Innenwiderstand kann mittels der folgenden Gleichung für den differentiellen Widerstand $R_{diff}$ bestimmt werden:

$$R_{diff} = \frac{dU}{dI}$$

Hierbei ist $dU$ das Spannungsdifferential und $dI$ ist das Stromdifferential.

Mittels der differenzierenden Filter $FILTER(\cdot)$ werden aus der erfassten Spannung $U$ und dem erfassten Strom $I$ das erfasste Spannungsdifferential und das modellierte Spannungsdifferential bestimmt:

$$dU_{erfasst} = FILTER(U)$$

$$dU_{Modell} = FILTER(I \cdot R_0)$$

Wenn ein Sprung im Strom erfolgt, so muss gelten:

$$dU_{erfasst} = dU_{Modell}$$

Aus einem Verhältnis der Spannungsdifferentiale kann dann ein Korrekturfaktor $\alpha_k$ bestimmt werden:

$$\frac{dU_{erfasst}}{dU_{Modell}} = \frac{R_0^{Real} dI}{f_k R_0^{Referenz} dI} = \alpha_k$$

Hierbei ist $R_0^{Referenz}$ insbesondere der nominelle Innenwiderstand der Batteriezelle, der als Referenzwert genommen wird, das heißt, insbesondere der Innenwiderstand, den die Batteriezelle bei Auslieferung aufgewiesen hat, wohingegen $R_0^{Real}$ der reale Innenwiderstand der Batteriezelle ist. Dieser reale Innenwiderstand wird insbesondere mittels der obigen Gleichung als aktueller Innenwiderstandschätzwert geschätzt und bereitgestellt.

Bei idealen Voraussetzungen kann ein neuer Korrekturfaktor $f$ für jede nachfolgende Iteration durch

$$f_{k+1} = \alpha_k f_k$$

erhalten werden.

Auf diese Weise kann für jeden Iterationsschritt aus der erfassten Spannung und dem erfassten Strom ein aktueller Innenwiderstandschätzwert geschätzt werden.

In einer Ausführungsform ist vorgesehen, dass die Filter als antisymmetrische Filter mit endlicher Impulsantwort ausgestaltet sind. Diese eignen sich besonders gut dafür, sowohl ein Differenzieren als auch eine Rauschverringerung erreichen zu können. Die Rauschverringerung erfolgt insbesondere durch ein Tiefpassverhalten des bzw. der Filter. Der antisymmetrische Filter mit endlicher Impulsantwort ist hierbei insbesondere derart ausgelegt, dass dieser differenzierend für niedrige Frequenzen ist und ein Rauschen verringert (Tiefpassverhalten).

In einer Ausführungsform ist vorgesehen, dass beim Bestimmen des Korrekturfaktors dieser mittels mindestens eines Schätzfilters geschätzt wird. Hierdurch können kurzfristige Schwankungen verringert werden. Insbesondere weist das mindestens eine Schätzfilter einen glättenden Effekt über die Zeit auf.

In einer weiterbildenden Ausführungsform ist vorgesehen, dass das mindestens eine Schätzfilter als Kalman-Filter ausgebildet ist. Der Vorteil ist, dass ein Kalman-Filter neben dem geschätzten Ergebnis zusätzlich auch ein Maß für die Konfidenz des geschätzten Ergebnisses bereitstellen kann, sodass zusätzlich eine Aussage zur Zuverlässigkeit des geschätzten Innenwiderstands der Batteriezelle bereitgestellt werden kann.

In einer Ausführungsform ist vorgesehen, dass mindestens eines der Spannungsdifferentiale mit einem vorgegebenen Schwellenwert verglichen wird, wobei die Maßnahmen zum Bestimmen des geschätzten Innenwiderstands ausgelöst werden, wenn ein Wert eines der Spannungsdifferentiale den vorgegebenen Schwellenwert erreicht oder überschreitet. Dies hat den Vorteil, dass die Maßnahmen zum Bestimmen des neuen aktuellen Innenwiderstands insbesondere (nur) dann durchgeführt werden, wenn zum Anlernen des Innenwiderstands der Batteriezelle ideale Bedingungen vorherrschen, das heißt, wenn eine große Spannungs- und/oder Stromänderung vorliegen, die zu einem guten Signal-zu-Rausch-Verhältnis führen. Ein geeigneter Schwellenwert kann beispielsweise empirisch und/oder durch Simulation ermittelt werden.

In einer Ausführungsform ist vorgesehen, dass eine Leistungsflussrichtung unterschieden wird, wobei hierzu eine Stromrichtung bestimmt wird und in Abhängigkeit der bestimmten Stromrichtung ein Ladeinnenwiderstandschätzwert und/oder ein Entladeinnenwiderstandschätzwert bestimmt und diese als leistungsflussrichtungsabhängige Innenwiderstände der Batteriezelle bereitgestellt werden. Hierdurch kann ein Innenwiderstand in Abhängigkeit des Leistungsflusses bestimmt werden. Das Vorgehen ist für die beiden Fälle grundsätzlich analog zu dem voranstehend beschriebenen Vorgehen. Insbesondere ist jedoch vorgesehen, dass für jede Leistungsflussrichtung (Laden/Entladen) ein eigener aktueller Innenwiderstandschätzwert bestimmt wird. Es wird insbesondere eine Richtung des Leistungsflusses bestimmt, insbesondere anhand einer Stromrichtung (bei entsprechender Spannung). Hierdurch kann ein Anlernen des bzw. der Korrekturfaktoren auch bei einem Vorzeichenwechsel des Stroms erfolgen. Erfolgt beispielsweise bei polaritätskonstanter Spannung ein Sprung im Strom von -100 A auf 50 A, so können die ersten zwei Drittel dieses Sprungs einer negativen Leistungsflussrichtung (z.B. Laden) zugeordnet werden, das letzte Drittel hingegen einer positiven Leistungsflussrichtung (z.B. Entladen). Die ersten zwei Drittel des Signalsprungs werden dann zum Schätzen des Innenwiderstands bei negativem Leistungsfluss und das letzte Drittel zum Schätzen des Innenwiderstands bei positivem Leistungsfluss verwendet. Beispielsweise können hierzu die einzelnen Werte des antisymmetrischen Filters mit endlicher Impulsantwort entsprechend bereichsweise ausgewertet werden. Hierzu wird der antisymmetrische Filter mit endlicher Impulsantwort zeitlich insbesondere auf die Mitte des Signalsprungs angeordnet. Da die Koeffizienten im ersten Teil des antisymmetrischen Filters negativ und im zweiten Teil des Filters positiv sind (oder umgekehrt), können die jeweiligen Teile zum Bestimmen eines gleitenden Mittelwertes der Stromwerte vor und nach dem Signalsprung mit Leistungsflusswechsel verwendet werden. Mittels der gleitenden Mittelwerte kann ein Signalrauschen reduziert werden, sodass ein Signal-zu-Rausch-Verhältnis verbessert werden kann.

Weitere Merkmale zur Ausgestaltung der Vorrichtung ergeben sich aus der Beschreibung von Ausgestaltungen des Verfahrens. Die Vorteile der Vorrichtung sind hierbei jeweils die gleichen wie bei den Ausgestaltungen des Verfahrens.

Ferner wird insbesondere auch ein Fahrzeug vorgeschlagen, umfassend mindestens eine Vorrichtung nach einer der beschriebenen Ausführungsformen. Ein Fahrzeug ist insbesondere ein Kraftfahrzeug. Grundsätzlich kann ein Fahrzeug aber auch ein anderes Land-, Schienen-, Wasser-, Luft- oder Raumfahrzeug sein. Grundsätzlich können das Verfahren und die Vorrichtung aber auch in anderen mobilen oder stationären Einrichtungen verwendet werden.

Nachfolgend wird die Erfindung anhand bevorzugter Ausführungsbeispiele unter Bezugnahme auf die Figuren näher erläutert. Hierbei zeigen:

Fig. 1          eine schematische Darstellung einer Ausführungsform der Vorrichtung zum Schätzen eines Innenwiderstandes einer Batteriezelle;

Fig. 2a         ein schematisches Diagramm des erfassten Stroms über der Zeit;

Fig. 2b         ein schematisches Diagramm des modellierten Spannungsdifferentials über der Zeit;

Fig. 3          eine schematische Darstellung zur Verdeutlichung einer Ausführungsform des Verfahrens;

Fig. 4a, 4b     schematische Diagramme zur Verdeutlichung des in dieser Offenbarung beschriebenen Verfahrens;

Fig. 5a, 5b     schematische Diagramme zur Verdeutlichung einer Ausführungsform des Verfahrens.

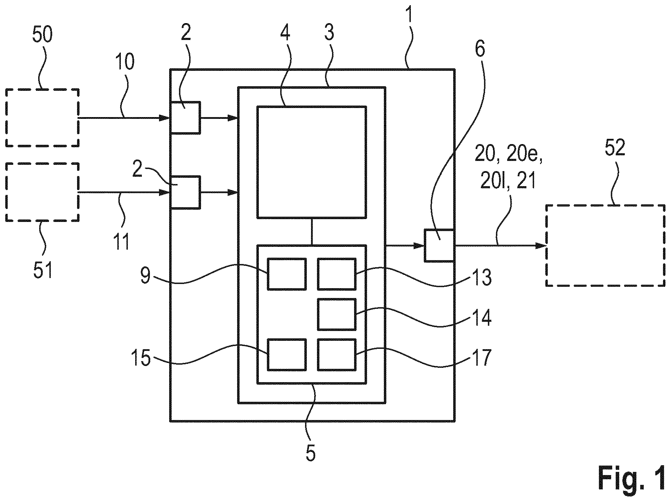

In Fig. 1 ist eine schematische Darstellung einer Ausführungsform der Vorrichtung 1 zum Schätzen eines Innenwiderstandes 20 einer Batteriezelle gezeigt. Die Vorrichtung 1 ist dazu eingerichtet, das in dieser Offenbarung beschriebene Verfahren auszuführen. Das Verfahren wird anhand der Vorrichtung 1 erläutert.

Die Vorrichtung 1 umfasst Schnittstellen 2, die eingerichtet sind zum Empfangen einer an der Batteriezelle erfassten Spannung 10 und eines an der Batteriezelle erfassten Stromes 11. Es kann sich auch um eine kombinierte Schnittstelle 2 handeln. Die Spannung 10 wird mittels eines Spannungssensors 50 an der Batteriezelle erfasst. Der Strom 11 wird mittels eines Stromsensors 51 an der Batteriezelle erfasst.

Ferner umfasst die Vorrichtung 1 eine Steuereinrichtung 3. Die Steuereinrichtung 3 umfasst eine Recheneinrichtung 4 und einen Speicher 5. Die Recheneinrichtung 4 ist beispielsweise ein Mikroprozessor oder ein Mikrocontroller, auf dem Programmcode ausgeführt wird, um das in dieser Offenbarung beschriebene Verfahren auszuführen. Es können jedoch auch festverdrahtete Hardwarekomponenten vorgesehen sein, die das Verfahren teilweise oder vollständig ausführen. Die Vorrichtung 1 kann auch Teil einer Batteriesteuerung (nicht gezeigt) sein.

Die Steuereinrichtung 3 ist dazu eingerichtet, ein erfasstes Spannungsdifferential 15 durch Differenzieren der erfassten Spannung 10 mittels eines Filters zu bestimmen. Das Filter ist insbesondere ein antisymmetrisches Filter mit endlicher Impulsantwort. Ferner ist die Steuereinrichtung 3 dazu eingerichtet, ein modelliertes Spannungsdifferential 13 aus dem erfassten Strom 11 und einem aktuellen Innenwiderstandschätzwert 9 durch Differenzieren mittels eines Filters zu bestimmen. Das Filter ist insbesondere ein antisymmetrisches Filter mit endlicher Impulsantwort.

Die Steuereinrichtung 3 bestimmt ferner einen Korrekturfaktor 17 aus dem erfassten Spannungsdifferential 15 und dem modellierten Spannungsdifferential 13. Ferner schätzt die Steuereinrichtung 3 einen neuen aktuellen Innenwiderstandschätzwert 9 aus dem bestimmten Korrekturfaktor 17 und dem vorherigen aktuellen Innenwiderstandschätzwert 9 und stellt den neuen aktuellen Innenwiderstandschätzwert 9 als geschätzten Innenwiderstand 20 der Batteriezelle bereit, beispielsweise als Innenwiderstandssignal 21, beispielsweise an einer Schnittstelle 6. Der geschätzte Innenwiderstand 20 bzw. das Innenwiderstandssignal 21 können beispielsweise einer Batteriesteuerung 52 zugeführt werden.

Es kann vorgesehen sein, dass beim Bestimmen des Korrekturfaktors 17 dieser mittels mindestens eines Schätzfilters geschätzt wird.

Weiterbildend kann vorgesehen sein, dass das mindestens eine Schätzfilter als Kalman-Filter ausgebildet ist.

Es kann vorgesehen sein, dass mindestens eines der Spannungsdifferentiale 13, 15 mit einem vorgegebenen Schwellenwert 14 verglichen wird, wobei die Maßnahmen zum Bestimmen des geschätzten Innenwiderstands 20 ausgelöst werden, wenn ein Wert eines der Spannungsdifferentiale 13, 15 den vorgegebenen Schwellenwert 14 erreicht oder überschreitet.

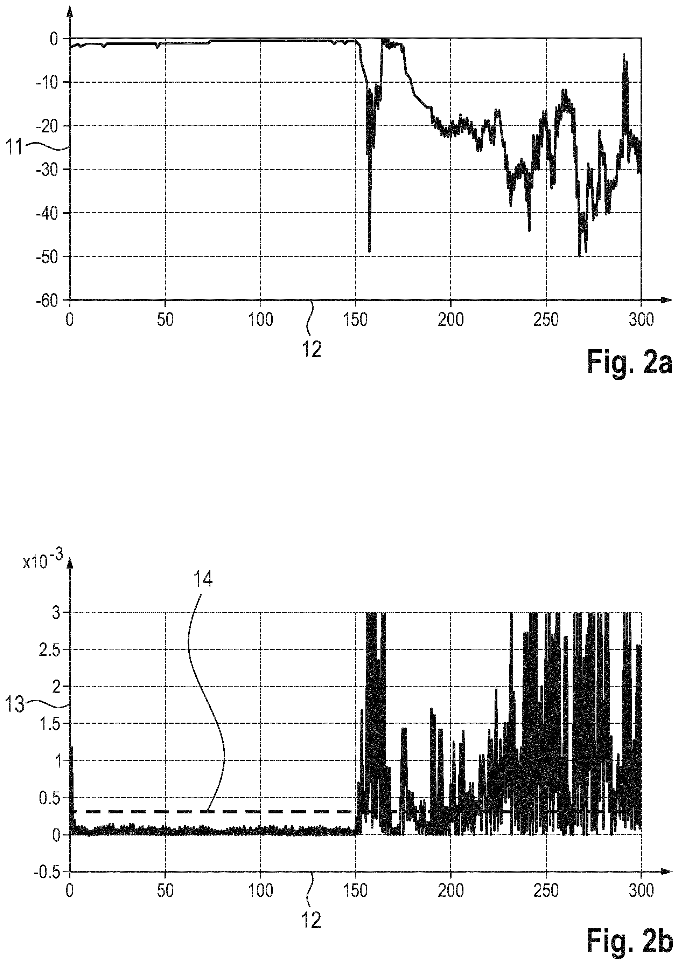

Dies ist schematisch in den Figuren 2a und 2b verdeutlicht. Die Fig. 2a zeigt den erfassten Strom 11 in A über der Zeit 12 in Sekunden. Die Fig. 2b zeigt den Absolutwert des modellierten Spannungsdifferentials 13 in Volt pro Sekunde über der Zeit 12 in Sekunden, das aus dem erfassten Strom 11 und dem aktuellen Innenwiderstandschätzwert der Batteriezelle durch Differenzieren mittels des Filters, insbesondere mittels des antisymmetrischen Filters mit endlicher Impulsantwort, bestimmt wurde. Zum Zeitpunkt von ca. 150 Sekunden überschreitet der Absolutwert des modellierten Spannungsdifferentials 13 den vorgegebenen Schwellenwert 14. Nach Erreichen oder Überschreiten des vorgegebenen Schwellenwertes 14 werden die Maßnahmen zum Bestimmen des geschätzten Innenwiderstands 20 durchgeführt, sodass ein aktualisierter geschätzter Innenwiderstand 20 (Fig. 1) der Batteriezelle bereitgestellt werden kann. Hierdurch können zum Anlernen des aktuellen Innenwiderstands 20 im Hinblick auf ein Signal-zu-Rauschverhältnis günstige Werte der Spannung 10 und des Stromes 11 verwendet werden.

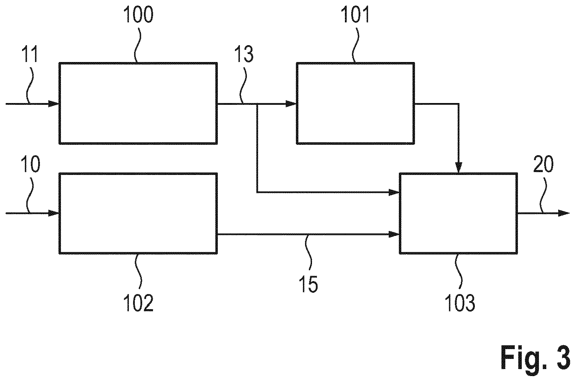

Diese Ausführungsform ist als schematisches Ablaufdiagramm in der Fig. 3 verdeutlicht. In der Steuereinrichtung 3 (Fig. 1) sind hierzu beispielsweise die Module 100 bis 103 ausgebildet (Fig. 3). Der erfasste Strom 11 wird in einem Modul 100 mit dem aktuellen Innenwiderstandschätzwert in eine Spannung umgerechnet. Diese Spannung wird mittels eines differenzierenden Filters, insbesondere mittels eines antisymmetrischen Filters mit endlicher Impulsantwort, in das modellierte Spannungsdifferential 13 umgerechnet. Dieses modellierte Spannungsdifferential 13 wird in einem Modul 101 mit einem vorgegebenen Schwellenwert verglichen (vgl. auch Fig. 2b). Ergibt der Schwellenwertvergleich in Modul 101 ein Erreichen oder Überschreiten, so werden in einem Modul 103 die Maßnahmen zum Bestimmen eines neuen aktuellen Innenwiderstandschätzwertes bzw. eines aktualisierten Innenwiderstandes 20 gestartet, anderenfalls wird der Schwellenwertvergleich mit aktuellen Werten für den erfassten Strom fortlaufend wiederholt.

Zum Ausführen der Maßnahmen im Modul 103 wird dem Modul 103 ein erfasstes Spannungsdifferential 15 zugeführt, welches in Modul 102 aus der erfassten Spannung 10 mittels eines differenzierenden Filters, insbesondere mittels eines antisymmetrischen Filters mit endlicher Impulsantwort, erzeugt wird. Ferner wird dem Modul 103 das modellierte Spannungsdifferential 13 zugeführt. In dem Modul 103 erfolgt dann das Anlernen eines (neuen aktualisierten) Korrekturfaktors, mit dem ein aktueller Innenwiderstand 20 der Batteriezelle geschätzt werden kann.

Es kann vorgesehen sein, dass eine Leistungsflussrichtung unterschieden wird. Hierzu bestimmt die Steuereinrichtung 3 (Fig. 1) eine Stromrichtung. Die Steuereinrichtung 3 bestimmt in Abhängigkeit der bestimmten Stromrichtung einen Ladeinnenwiderstandschätzwert und/oder einen Entladewiderstandschätzwert und stellt diese als leistungsflussrichtungsabhängige Innenwiderstände 20l, 20e (Laden, Entladen) der Batteriezelle bereit.

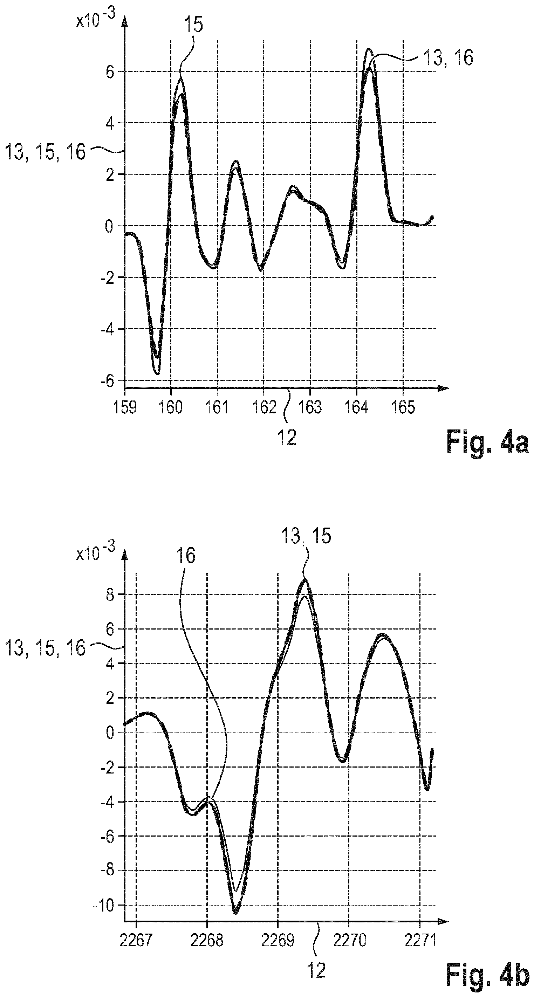

In den Figuren 4a und 4b sind schematische Diagramme zur Verdeutlichung des in dieser Offenbarung beschriebenen Verfahrens gezeigt. Gezeigt sind Verläufe des erfassten Spannungsdifferentials 15 sowie eines Spannungsdifferentials 16, das mit Hilfe des nominellen Innenwiderstands (als Referenzinnenwiderstand bzw. Startinnenwiderstand) der Batteriezelle bestimmt wurde, und des modellierten Spannungsdifferentials 13 in V über der Zeit 12 in Sekunden. Es ist zu erkennen, dass zu Beginn des Verfahrens, das heißt nach etwa 160 Sekunden (Fig. 4a) das modellierte Spannungsdifferential 13 mit dem Spannungsdifferential 16 übereinstimmt und Abweichungen zum erfassten Spannungsdifferential 15, insbesondere an den Peaks, aufweist. Nach etwa 2270 Sekunden hat sich das modellierte Spannungsdifferential 13 hingegen dem erfassten Spannungsdifferential 15 angeglichen, dies erfolgte insbesondere durch Anpassen des aktuellen Innenwiderstandschätzwertes über den Korrekturfaktor. Der Lerneffekt ist also deutlich zu erkennen.

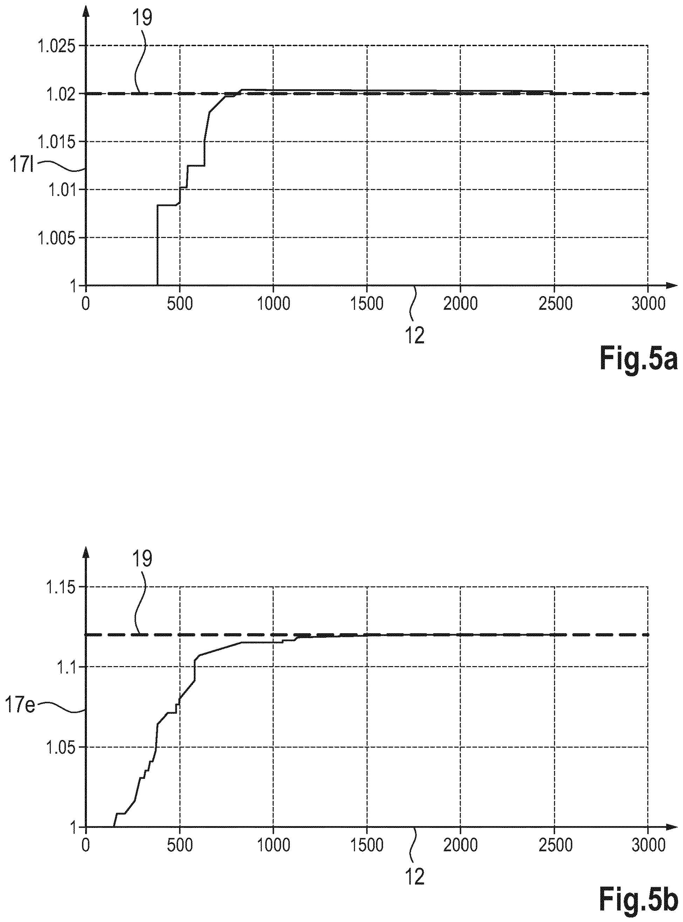

In den Figuren 5a und 5b sind schematische Diagramme zur Verdeutlichung einer Ausführungsform des Verfahrens gezeigt. Es ist vorgesehen, dass eine Leistungsflussrichtung unterschieden wird, wobei hierzu eine Stromrichtung bestimmt wird und in Abhängigkeit der bestimmten Stromrichtung ein Ladeinnenwiderstandschätzwert und/oder ein Entladewiderstandschätzwert bestimmt und diese als leistungsflussrichtungsabhängige Innenwiderstände der Batteriezelle bereitgestellt werden. Ferner ist in der Ausführungsform vorgesehen, dass beim Bestimmen der Korrekturfaktoren 17l, 17e diese mittels jeweils eines Schätzfilters geschätzt werden, wobei die Schätzfilter jeweils als Kalman-Filter ausgebildet sind.

In der Fig. 5a ist der Korrekturfaktor 17l, 17e des Ladeinnenwiderstandschätzwertes über der Zeit 12 in Sekunden dargestellt. In der Fig. 5b ist der Korrekturfaktor 17l, 17e des Entladeinnenwiderstandschätzwertes über der Zeit 12 in Sekunden dargestellt. Es ist zu erkennen, dass sich die Werte der Korrekturfaktoren 17l, 17e für den Ladeinnenwiderstandschätzwert und den Entladeinnenwiderstandschätzwert voneinander unterscheiden. Entsprechend unterscheiden sich auch der mittels des Korrekturfaktors 17l bestimmte Ladeinnenwiderstandschätzwert und der mittels des Korrekturfaktors 17e bestimmte Entladeinnenwiderstandschätzwert voneinander.

Ferner ist deutlich zu erkennen, wie von einem anfänglichen Wert (=1) der Korrekturfaktoren 17l, 17e der jeweilige Wert schrittweise über die Zeit sich einem Wert der jeweiligen Grundwahrheit 19 annähert.

Das Verfahren und die Vorrichtung ermöglichen es, zuverlässig einen Innenwiderstand einer Batteriezelle zu schätzen. Vorteile sind insbesondere ein Anlernen eines Korrekturfaktors immer dann, wenn ein Signal-zu-Rauschverhältnis günstig ist. Ferner können leistungsflussabhängige Innenwiderstände geschätzt und bereitgestellt werden, sodass zwischen einem Innenwiderstand beim Laden und einem Innenwiderstand beim Entladen unterschieden werden kann.

Bezugszeichenliste

| 1 | Vorrichtung |
| 2 | Schnittstelle |
| 3 | Steuereinrichtung |
| 4 | Recheneinrichtung |
| 5 | Speicher |
| 6 | Schnittstelle |
| 9 | aktueller Innenwiderstandschätzwert |
| 10 | erfasste Spannung |
| 11 | erfasster Strom |
| 12 | Zeit |
| 13 | modellierter Spannungsdifferential |
| 14 | vorgegebener Schwellenwert |
| 15 | erfasstes Spannungsdifferential |
| 16 | Spannungsdifferential (Referenzinnenwiderstand) |
| 17 | Korrekturfaktor |
| 17l | Korrekturfaktor (Laden) |
| 17e | Korrekturfaktor (Entladen) |
| 19 | Grundwahrheit |
| 20 | Innenwiderstand |
| 20l | Innenwiderstand (Laden) |
| 20e | Innenwiderstand (Entladen) |
| 21 | Innenwiderstandssignal |
| 50 | Spannungssensor |
| 51 | Stromsensor |
| 52 | Batteriesteuerung |
| 100-103 | Module |

## Patentansprüche

1. Verfahren zum Schätzen eines Innenwiderstandes (20) einer Batteriezelle, umfassend die folgenden Maßnahmen:

   Erfassen einer Spannung (10) an der Batteriezelle,
   Erfassen eines Stromes (11) an der Batteriezelle,
   Bestimmen eines erfassten Spannungsdifferentials (15) durch Differenzieren der erfassten Spannung (10) mittels eines Filters,
   Bestimmen eines modellierten Spannungsdifferentials (13) aus dem erfassten Strom (11) und einem aktuellen Innenwiderstandschätzwert durch Differenzieren mittels eines Filters, Bestimmen eines Korrekturfaktors (17) aus dem erfassten Spannungsdifferential (15) und dem modellierten Spannungsdifferential (13), und
   Schätzen eines neuen aktuellen Innenwiderstandschätzwertes aus dem bestimmten Korrekturfaktor (17) und dem vorherigen aktuellen Innenwiderstandschätzwert,
   Bereitstellen des neuen aktuellen Innenwiderstandschätzwertes als geschätzten Innenwiderstand (20) der Batteriezelle.

2. Verfahren nach Anspruch 1, **dadurch gekennzeichnet, dass** die Filter als antisymmetrische Filter mit endlicher Impulsantwort ausgestaltet sind.

3. Verfahren nach Anspruch 1 oder 2, **dadurch gekennzeichnet, dass** beim Bestimmen des Korrekturfaktors (17) dieser mittels mindestens eines Schätzfilters geschätzt wird.

4. Verfahren nach Anspruch 3, **dadurch gekennzeichnet, dass** das mindestens eine Schätzfilter als Kalman-Filter ausgebildet ist.

5. Verfahren nach einem der vorangegangene Ansprüche, **dadurch gekennzeichnet, dass** mindestens eines der Spannungsdifferentiale (13,15) mit einem vorgegebenen Schwellenwert (14) verglichen wird, wobei die Maßnahmen zum Bestimmen des geschätzten Innenwiderstands (20) ausgelöst werden, wenn ein Wert eines der Spannungsdifferentiale (13,15) den vorgegebenen Schwellenwert (14) erreicht oder überschreitet.

6. Verfahren nach einem der vorangegangenen Ansprüche, **dadurch gekennzeichnet, dass** eine Leistungsflussrichtung unterschieden wird, wobei hierzu eine Stromrichtung bestimmt wird und in Abhängigkeit der bestimmten Stromrichtung ein Ladeinnenwiderstandschätzwert und/oder ein Entladeinnenwiderstandschätzwert bestimmt und diese als leistungsflussrichtungsabhängige Innenwiderstände (20) der Batteriezelle bereitgestellt werden.

7. Vorrichtung (1) zum Schätzen eines Innenwiderstandes (20) einer Batteriezelle, umfassend:

Schnittstellen (2), die eingerichtet sind zum Empfangen einer an der Batteriezelle erfassten Spannung (10) und eines an der Batteriezelle erfassten Stromes (11), und eine Steuereinrichtung (3), wobei die Steuereinrichtung (3) dazu eingerichtet ist,
ein erfasstes Spannungsdifferential (15) durch Differenzieren der erfassten Spannung (10) mittels eines Filters zu bestimmen,
ein modelliertes Spannungsdifferential (13) aus dem erfassten Strom (11) und einem aktuellen Innenwiderstandschätzwert durch Differenzieren mittels eines Filters zu bestimmen,
einen Korrekturfaktor (17) aus dem erfassten Spannungsdifferential (15) und dem modellierten Spannungsdifferential (13) zu bestimmen, und
einen neuen aktuellen Innenwiderstandschätzwert aus dem bestimmten Korrekturfaktor (17) und dem vorherigen aktuellen Innenwiderstandschätzwert zu schätzen, und
den neuen aktuellen Innenwiderstandschätzwert als geschätzten Innenwiderstand (20) der Batteriezelle bereitzustellen.

8. Vorrichtung (1) nach Anspruch 7, **dadurch gekennzeichnet, dass** die Filter als antisymmetrische Filter mit endlicher Impulsantwort ausgestaltet sind.

9. Vorrichtung (1) nach Anspruch 7 oder 8, **dadurch gekennzeichnet, dass** beim Bestimmen des Korrekturfaktors (17) dieser mittels mindestens eines Schätzfilters geschätzt wird.

10. Vorrichtung (1) nach Anspruch 9, **dadurch gekennzeichnet, dass** das mindestens eine Schätzfilter als Kalman-Filter ausgebildet ist.

**Claims**

1. Method for estimating an internal resistance (20) of a battery cell, comprising the following measures:

detecting a voltage (10) at the battery cell,
detecting a current (11) at the battery cell,

determining a detected voltage differential (15) by differentiating the detected voltage (10) by means of a filter,
determining a modeled voltage differential (13) from the detected current (11) and a present internal resistance estimated value by differentiating by means of a filter, determining a correction factor (17) from the detected voltage differential (15) and the modeled voltage differential (13), and
estimating a new present internal resistance estimated value from the determined correction factor (17) and the previous present internal resistance estimated value, and providing the new present internal resistance estimated value as the estimated internal resistance (20) of the battery cell.

2. Method according to claim 1, **characterized in that** the filters are designed as antisymmetric filters which have a finite impulse response.

3. Method according to claim 1 or 2, **characterized in that,** when determining the correction factor (17), the correction factor is estimated by means of at least one estimation filter.

4. Method according to claim 3, **characterized in that** the at least one estimation filter is designed as a Kalman filter.

5. Method according to any of the preceding claims, **characterized in that** at least one of the voltage differentials (13, 15) is compared with a predetermined threshold value (14), the measures for determining the estimated internal resistance (20) being triggered when a value of one of the voltage differentials (13, 15) reaches or exceeds the predetermined threshold value (14).

6. Method according to any of the preceding claims, **characterized in that** a power flow direction is distinguished, a current direction being determined for this purpose and, depending on the determined current direction, a charging internal resistance estimated value and/or a discharging internal resistance estimated value being determined, and these being provided as internal resistances (20) of the battery cell, which are dependent on a power flow direction.

7. Apparatus (1) for estimating an internal resistance (20) of a battery cell, comprising:

interfaces (2) which are configured to receive a voltage (10) detected at the battery cell and a current (11) detected at the battery cell, and a control device (3), wherein the control device (3) is configured to determine a detected voltage differential (15) by differentiating the detected voltage (10) by means of a filter,
to determine a modeled voltage differential (13) from the detected current (11) and a present internal resistance estimated value by differentiating by means of a filter,
to determine a correction factor (17) from the detected voltage differential (15) and the modeled voltage differential (13), and to estimate a new present internal resistance estimated value from the determined correction factor (17) and the previous present internal resistance estimated value, and
to provide the new present internal resistance estimated value as the estimated internal resistance (20) of the battery cell.

8. Apparatus (1) according to claim 7, **characterized in that** the filters are designed as antisymmetric filters which have a finite impulse response.

9. Apparatus (1) according to claim 7 or 8, **characterized in that,** when determining the correction factor (17), the correction factor is estimated by means of at least one estimation filter.

10. Apparatus (1) according to claim 9, **characterized in that** the at least one estimation filter is designed as a Kalman filter.


## Revendications

1. Procédé d'estimation d'une résistance interne (20) d'un élément de batterie, comprenant les mesures suivantes :

détection d'une tension (10) aux bornes de l'élément de batterie,
détection d'un courant (11) aux bornes de l'élément de batterie,
détermination d'un différentiel de tension (15) détecté en différenciant la tension (10) détectée au moyen d'un filtre,
détermination d'un différentiel de tension (13) modélisé à partir du courant (11) détecté et d'une valeur estimée de résistance interne actuelle par différenciation au moyen d'un filtre,
détermination d'un facteur de correction (17) à partir du différentiel de tension (15) détecté et du différentiel de tension (13) modélisé, et
estimation d'une nouvelle valeur estimée de résistance interne actuelle à partir du facteur de correction (17) déterminé et de la valeur estimée de résistance interne actuelle précédente, fourniture de la nouvelle valeur estimée de résistance interne actuelle en tant que résistance interne (20) estimée de l'élément de batterie.

2. Procédé selon la revendication 1, **caractérisé en ce que** les filtres sont conçus comme des filtres antisymétriques avec une réponse impulsionnelle finie.

3. Procédé selon la revendication 1 ou 2, **caractérisé en ce que,** lors de la détermination du facteur de correction (17), celui-ci est estimé au moyen d'au moins un filtre d'estimation.

4. Procédé selon la revendication 3, **caractérisé en ce que** l'au moins un filtre d'estimation est réalisé comme un filtre de Kalman.

5. Procédé selon l'une des revendications précédentes,
**caractérisé en ce qu'**au moins l'un des différentiels de tension (13, 15) est comparé à une valeur seuil (14) prédéfinie, dans lequel les mesures pour déterminer la résistance interne (20) estimée sont déclenchées lorsqu'une valeur de l'un des différentiels de tension (13, 15) atteint ou dépasse la valeur seuil (14) prédéfinie.

6. Procédé selon l'une des revendications précédentes,
**caractérisé en ce que** l'on distingue un sens de flux de puissance, dans lequel un sens de courant est déterminé à cet effet et une valeur estimée de résistance interne de charge et/ou une valeur estimée de résistance interne de décharge sont déterminées en fonction du sens de courant déterminé et celles-ci sont fournies en tant que résistances internes (20) de l'élément de batterie dépendant du sens de flux de puissance.

7. Dispositif (1) d'estimation d'une résistance interne (20) d'un élément de batterie, comprenant :

des interfaces (2) destinées à recevoir une tension (10) détectée aux bornes de l'élément de batterie et un courant (11) détecté aux bornes de l'élément de batterie, et un dispositif de commande (3), dans lequel le dispositif de commande (3) est destiné à déterminer un différentiel de tension (15) détecté en différenciant la tension (10) détectée au moyen d'un filtre, déterminer un différentiel de tension (13) modélisé à partir du courant (11) détecté et d'une valeur estimée de résistance interne actuelle par différenciation au moyen d'un filtre, déterminer un facteur de correction (17) à partir du différentiel de tension (15) détecté et du différentiel de tension (13) modélisé, et estimer une nouvelle valeur estimée de résistance interne actuelle à partir du facteur de correction (17) déterminé et de la valeur estimée de résistance interne actuelle précédente, et fournir la nouvelle valeur estimée de résistance interne actuelle en tant que résistance interne (20) estimée de l'élément de batterie.

8. Dispositif (1) selon la revendication 7, **caractérisé en ce que** les filtres sont conçus comme des filtres antisymétriques avec une réponse impulsionnelle finie.

9. Dispositif (1) selon la revendication 7 ou 8, **caractérisé en ce que,** lors de la détermination du facteur de correction (17), celui-ci est estimé au moyen d'au moins un filtre d'estimation.

10. Dispositif (1) selon la revendication 9, **caractérisé en ce que** l'au moins un filtre d'estimation est réalisé comme un filtre de Kalman.

Fig. 1

Fig. 2a

Fig. 2b

Fig. 3

Fig. 4a

Fig. 4b

Fig.5a

Fig.5b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- CN 111426968 A
- JP 2008164417 A